# EUROPEAN PATENT SPECIFICATION

(11) **EP 0 411 422 B1**
(45) Date of publication and mention of the grant of the patent: **18.05.1994**
(21) Application number: 90114036.8
(22) Date of filing: 23.07.1990
(51) Int. Cl.: H03J 9/06, H04N 17/04

(54) **Improved television receiver**
Verbesserter Fernsehempfänger
Récepteur de télévision amélioré

(30) Priority: 31.07.1989 IT 6764989
(43) Date of publication of application: 06.02.1991
(73) Proprietor: EDICO S.r.l., I-00197 Roma (IT)
(72) Inventor: Farina, Attilio, I-10127 Torino (IT)

(56) References cited:
- EP-A- 0 172 640
- US-A- 4 006 461
- PATENT ABSTRACTS OF JAPAN, vol. 11, no. 309 (E-547) (2756), 8th October 1987 & JP-A-62 102 656
- PATENT ABSTRACTS OF JAPAN, vol. 7, no. 158 (E-186)[1303], 12th July 1983 & JP-A-58 68 388

## Description

Present invention refers to a television receiver, comprising an image displaying device, a reproducing means of acoustic signals and a data transmission port which may be coupled to a modem and to a telephone line.

It is known that one of the main problems of television receivers, considering the notable complexity of their electronic circuits, even more complex with the passing of time, is that of their failures or misfunctionings and the difficulties to repair them. In fact it is not easy to find service stations well equipped with the necessary sofisticated apparatus, and having specialized technicians.

Especially out of the main towns, such stations are not available, and as a consequence it is necessary to take the television receiver to the nearest town, where such a station is available. This costs time and money.

An alternative is to replace a part of the apparatus, instead of finding the fault, that might be small, and execute the relevant repair.

Such alternative is clearly expensive and represents a waste.

It is known from JP-A-62 102 656 and the relevant english language abstract a transmission system for data for repair and service, where, when a fault in a TV set is noticed, a service personnel visits the customer carrying a hand held computer and a modem; then the technician checks the manufacture number of the receiver; adjusting data of the receiver is called from a central data bank via telephone line and modem, rewriting the data in a memory in the TV receiver.

It is an object of the present invention to indicate how it is possible to implement an improved television receiver which permits a simplification of the repair, even in places distant from well equipped service stations.

To achieve the said object, the subject of the present invention is a television receiver, comprising an image displaying device, a reproducing means of acoustic signals, a data transmission port which may be coupled to a modem and to a telephone line, a control device and a logical circuit, apt to respond to a predetermined command, given by the user through said control device and to supply as a consequence to said port, a sequence of signals, in order to enable a data transmission, through said modem and the telephone line, to a distant receiving station, characterized in that said data transmission contains information on the working condition of the television receiver, and that the receiver comprises also circuit means, connected to said logical circuit and to said port, for receiving from said distant station signals as an answer to said data transmission, and communicating said answer to the user.

The invention is based on the fact that many recent television sets are provided with a microprocessor in order to control several functions of the receiver; and that it is relatively simple to use said microprocessor, programming it suitably, so that following a determined command given by the user through the control device (e.g. the remote control keyboard), the microprocessor sends to the serial port a sequence of coded data, relevant to the working condition of the television receiver, and suitable to be transmitted, by the modem and the telephone line, to a distant station, which is equipped for analysing, by means of a central computer, such data, getting a diagnosis of the causes of the television receiver's misfunctioning, and the instructions for repair by a technician; such main station will transmit the instructions to the television receiver, which will in turn provide to display them on the television receiver's screen, by a character generator, for instance a generator given as standard to the television receivers able to receive Televideo pages (Teletext).

The instructions can be read by the technician, which will enable him to make the repair.

It is clear that this system can only function when the fault is thus that at least a partial working of the television receiver is possible (for instance only the sound is missing, or only the picture, or there is only noise worsening the quality of reception, etc.), and the system can not function in the case of total failure.

In the last case the determination of the fault is generally easier, both for the semplicity of the interested circuit (mains supply), and because often there are visible traces (burnout, etc.).

The transmission-reception of data may be started by pressing a suitable combination (of unlikely accidental occurence) of keys of the remote control, for instance pressing simultaneously or in succession two keys (c/p and mute) and twice a number (00); or can by pressing a dedicated key.

A television receiver already provided with a keyboard, a character generator, a microprocessor and a ROM memory is for instance known by the European patent application No 0 219 703, and can constitute a valid starting point to implement the invention.

Other objects and advantages of the present invention will be clear from the detailed description which follows and from the attached drawings, which are supplied only as an explanatory and not limiting example.

In the drawings:
figure 1 shows a block diagram of the part of the receiver's circuit which is of interest for the implementation of the invention;
figure 2 shows schematically the blocks of the logical circuitry which allows the implementation of the principles of the invention.

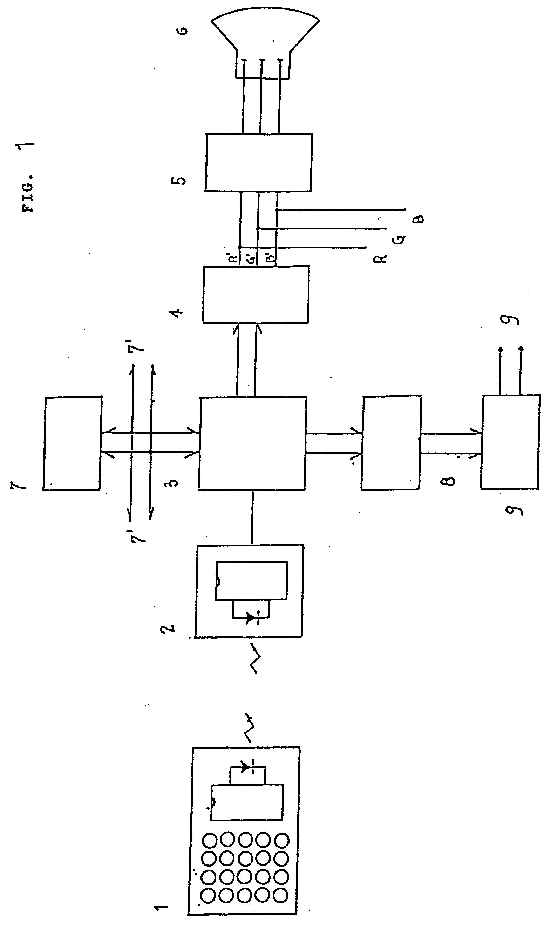

In figure 1, which schematically shows a block diagram of the part of the receiver's circuit which is of interest for the implementation of the invention, reference number 1 indicates an infrared remote control transmitter comprising a keyboard having a plurality of keys, which provides for remote-controlling the receiver, among which there are at least 10 bearing the numbers from 0 to 9; reference number 2 indicates the relevant infrared receiver, which provides for receiving and decoding the signals coming from device 1. Said devices 1 and 2 are of a known type, usually present on the majority of recent production television sets; therefore we will not give more details thereon; they can be easily got from customary component suppliers.

With reference number 3 a control unit is indicated, which in the relevant example comprises a suitable microprocessor, e.g. of the 8 or 16 bits type usually found on television sets; for instance a Z80 or a MC68000.

Said microprocessor is connected to a memory (indicated with reference number 7); the memory 7 can be a RAM type memory (a modifiable memory, that is a read/write one); the microprocessor is connected to the television's mains circuitry by a bus of data 7'. With reference number 4 a character generator is indicated, for instance a Teletext compatible generator, able to display on a television screen 24 lines of 40 characters each; a character generator of the said type is e.g. described in the cited European patent No 0 219 703.

Character generator 4 is connected to a colour television video amplifying circuit (indicated with reference number 5), of a known type; said circuit 5 comprises three input terminals for receiving three colour signals R (red), G (green) and B (blue); said terminals may be connected, besides to the character generator 4, also to three correspondent terminals pertaining to normal television receiving circuitry (in order to display a normal television picture).

Circuit 5 comprises three output terminals too, connected to a colour display (indicated with reference number 6), which in the present case is a normal shadow mask picture tube.

With reference number 8 a data port is indicated of the serial, or parallel type, connected by a plurality of wires to the logical unit 3; such port may be for instance wired according to the known standard RS 232, or one of the more widespread types of parallel ports; to said port a modem 9 can be connected, which can be connected to a telephone line 9'. Said modem 9 may also be of the acoustic coupler type.

The operation of the described circuit is as follows:
when on the keyboard of the remote control transmitter 1 a predetermined combination is keyed, for instance the combination of two zeroes (00), preceded by the pressing of two keys for instance the key generally indicated by the symbol C/P (channel/program) and the key for "muting", which serves to temporarily disconnect the loudspeaker (generally indicated by the symbol of an erased loudspeaker), and said combination, suitably coded, is transmitted by means of the infrared rays to the receiver 2, the latter decodes and sends it to control unit 3.

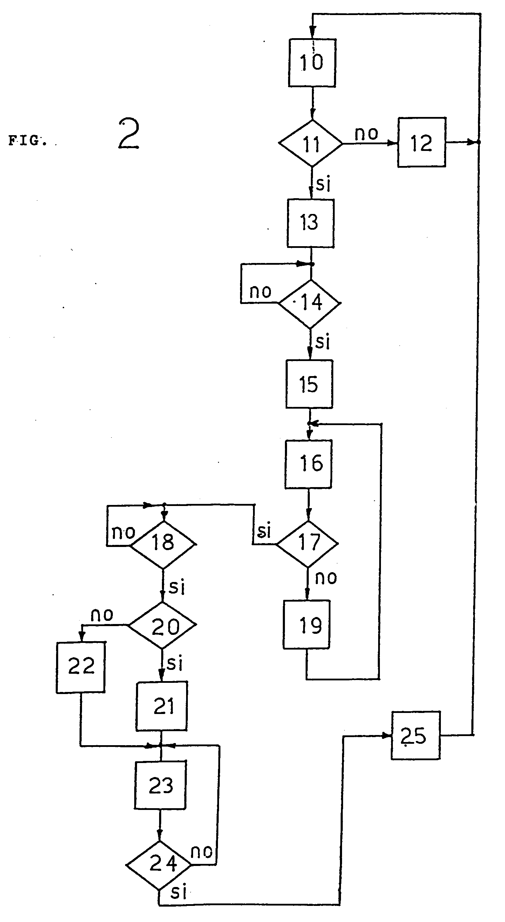

As will be explained in more detail later, referring to figure 2, control unit 3
- aknowledges the predetermined combination;
- sends to port 8 and to modem 9 the command for estabilishing a connection with a distant receiving station, dials a predetermined telephone number, previously memorized in a suitable way (by another command given through the keyboard 1) in the memory 7 or in another suitable way (for instance in a little memory of EEPROM type, modifiable but less easily than a RAM type, therefore more protected); in the case in which the modem should not be able to dial the number that shall be called, the microprocessor can be equipped with a supplementary connection which connects it directly to the line 9', without passing through the modem and the telephone receiver (said supplementary line is not represented in the figure);
- waits the signal that the connection has been estabilished;
- provides for extracting from the memory 7 a sequence of data previously memorized, which refers to the working condition of the television receiver (received through the data bus 7') and sends them to port 8, which in turn sends them, suitably coded, to the telephone line 9';
- awaits an answer signal from the distant station;
- decodes the signals received from the distant station; they contain at the beginning an instruction relating to the means of transmission of the answer for the operator; if the screen is operating, the answer must be visualized on the screen; if the screen is out of use, but the audio is operating, the answer can be furnished in sound form by loudspeaker;
- sends the answer in the indicated way (video or audio); in the first case the data are sent to the character generator 4 which transmits them to amplifier 5 and to picture tube 6; the said series of characters is therefore displayed on the television's screen; colours may be utilized to highlight the most important words; in the second case sends the answer to the audio channel (for instance the answer should be reproduced with a code of Morse type, inserted in the service manual), or a vocal syntesizer of known type may be used.

In the example that we are describing, the series of data transmitted to the distant station, are examined by the central computer, for instance when there is a fault in the sound part of the television receiver, which is due to a failure of the audio demodulator, the answer will be displayed as a message of the type:
"Check the audio demodulator".

In the case of a darkened screen, the diagnosis would be a probable failure in the part which generates the extra high tension for the picture tube; in such a case an answer, of the type "Check the E.H.T. generator", should be reproduced by the audio amplifier in a suitable code (for instance the letter "E" in Morse alphabet), or in a synthesized form.

In figure 2, there are schematically shown the blocks of the logical circuitry which allows to implement the principles of the invention, reference number 10 indicates a logical block which represents the starting point of the relevant function; said block 10 corresponds to the condition in which the microprocessor waits a signal coming from the device 1.

At the moment when a signal arrives, the control passes to the next block 11; block 11 is a test block, which checks if the received signal corresponds to the special signal or to the special combination previously established; in the affirmative case (output SI) the control passes to block 13; in the negative case (output NO) the control passes to block 12.

Block 12 indicates schematically the execution of all the functions corresponding to other possible control signals for which the microprocessor is predisposed to operate; then block 12 returns control to the first block 10.

Block 13 on the contrary sends to port 8 the instruction for the modem to call the number of the distant station and establish a connection with it; for this purpose said number will be stored in the memory 7 or in another suitable memory; block 13 then passes the control to the next block 14.

Block 14 is a test block, which provides for verifying if from the modem there has arrived a signal that the connection has been established; in the affirmative case (output SI) the control passes to block 15; in the negative case (output NO) the control goes back to block 14.

Block 15 sends to memory 7 the appropriate address for reading the data which must be transmitted, and then passes the control to the next block 16.

Block 16 reads data from the memory 7 and sends it to port 8; it then passes the control to block 17.

Block 17 is a test block, which checks if the data read correspond to data which indicate that the transmission has finished; in the affirmative case (output SI) the control passes to block 18; in the negative case (output NO) the control passes to block 19.

Block 18 is test block, which checks if the answer signal has arrived from the distant station at the port 8; in the affirmative case (output SI) the control passes to block 20; in the negative case (output NO) the control returns to block 18.

Block 19 provides for incrementing the address of the memory and passes the control to block 16 again.

Block 20 is a test block, which checks if the first arrived signal from the port 8 indicates that an acoustic transmission of the instructions is needed; in the affirmative case (output SI) the control passes to block 21; in the negative case (output NO) the control passes to block 22.

Block 21 provides for preparing the appropriate commutations for sending the message to the acoustics channel and passes the control to block 23; the block 22 prepares the appropriate commutations for sending the message to the video channel (generator 4) and passes the control to block 23.

Block 23 receives the signal that comes from the port 8 and sends it to the choosen channel, then passes the control to block 24.

Block 24 is a test block, which checks if the last signal received from the port 8 indicates the end of the transmission; in the affirmative case (output SI) the control passes to block 25; in the negative case (output NO) the control returns to block 23.

Block 25 provides to instruct the modem 9 to 'hang up' the telephone and passes again the control to initial block 10.

All the transmissions from the unit 3 to port 8 and vice versa are assumed to be executed according to a suitable protocol of 'handshaking', which can be one of the many known standards.

As it clearly results from the given description, the improved television receiver according to the invention, allows to activate a connection with a computerized central station, to which are sent a sequence of coded data, relative to the working conditions of the television receiver; as an answer the television receiver receives a diagnosis of the causes of its misfunctioning and the relevant instruction for the technician, for making the necessary repairs.

In this way there is obtained an efficient assistance for the technician with a considerable saving of time and money.

Subject to the invention's principle, many variations to the manufacturing characteristics of improved television receiver described as an example are possible, without departing from the novelty principles inherent to the invention.

It is not necessary that the set comprises a microprocessor, even if this is the simplest way to implement the invention; in fact it is well known that a microprocessor operates with a programmed logic, but that the same result may be obtained using an equivalent wired logic; in a specific case it is necessary to have a wired logic corresponding to the block diagram of figure 2, which is able to detect the key command and, as a consequence, to provide for starting the sequence of necessary events to realize the transmission of data via telephone and the following to that the reception of the answers or instructions.

## Claims

1. Television receiver, comprising an image displaying device (6), a reproducing means of acoustic signals, a data transmission port (8) which may be coupled to a modem (9) and to a telephone line (9'), a control device (1) and a logical circuit (3), apt to respond to a predetermined command, given by the user through said control device (1) and to supply as a consequence to said port (8), a sequence of signals, in order to enable a data transmission, through said modem (9) and the telephone line (9'), to a distant receiving station, characterized in that said data transmission contains information on the working condition of the television receiver, and that the receiver comprises also circuit means (4,5), connected to said logical circuit (3) and to said port (8), for receiving from said distant station signals as an answer to said data transmission, and communicating said answer to the user.

2. Television receiver, according to claim 1, characterized in that said answer is communicated to the user either displaying consequent instructions onto said image displaying device (6) or reproducing them by means of said reproducing means of acoustic signals.

3. Television receiver, according to claim 2, characterized in that said instructions are reproduced in acoustic form according to Morse signals, correspondent to instructions according to an established code.

4. Television receiver, according to any one of the preceding claims, characterized in that said logical circuit comprises a microprocessor (3) and a memory circuit (7).

5. Television receiver, according to any one of the preceding claims, characterized in that said logical circuit (3) comprises a plurality of logical ports, connected in a network by wired logic.

6. Television receiver, according to any one of the preceding claims, characterized in that said modem (9) is incorporated in the television receiver.

7. Television receiver, according to any one of the preceding claims from 1 to 5, characterized in that said modem (9) is of the acoustic coupler type.

8. Television receiver, according to any one of the preceding claims, characterized in that there is the possibility of memorizing in a circuit of memory, inside the receiver, the telephone number that the receiver, by means of the logical circuit (3), can call to activate the telephone connection with the distant station.

9. Television receiver, according to claim 8, characterized in that said telephone number which must be memorized can be input on the receiver's remote control keyboard.

## Patentansprüche

1. Fernsehempfänger, bestehend aus einer Bildanzeigevorrichtung (6), einer Wiedergabevorrichtung akustischer Signale, einem Datenübertragungsanschluß (8), der an ein Modem (9) und an eine Telefonleitung (9') angeschlossen werden kann, einer Bedienungsvorrichtung (1) und einer logischen Schaltung (3), die auf einen vorbestimmten Befehl ansprechen kann, der vom Benutzer über die Bedienungsvorrichtung (1) eingegeben wird, und als Antwort an das Anschlußteil (8) eine Reihe von Signalen abgibt, um über das Modem (9) und die Telefonleitung (9') eine Datenübertragung an eine entfernte Empfangsstation zu ermöglichen, **dadurch gekennzeichnet,** daß die Datenübertragung Informationen über den Betriebszustand des Fernsehempfängers enthält, und daß der Empfänger auch Schaltvorrichtungen (4, 5) aufweist, die mit der logischen Schaltung (3) und dem Anschlußteil (8) verbunden sind, um von der entfernten Station Signale als Antwort auf die Datenübertragung zu empfangen und die Antwort an den Benutzer zu übertragen.

2. Fernsehempfänger nach Anspruch 1, dadurch gekennzeichnet, daß die Antwort an den Benutzer entweder durch Anzeige entsprechender Anweisungen auf der Bildanzeigevorrichtung (6) oder durch Wiedergabe derselben mittels der Wiedergabevorrichtung akustischer Signale übertragen wird.

3. Fernsehempfänger nach Anspruch 2, dadurch gekennzeichnet, daß die Anweisungen akustisch gleich Morsesignalen wiedergegeben werden, die Anweisungen gemäß einem festgelegten Code entsprechen.

4. Fernsehempfänger nach einem der vorhergehenden Ansprüche, dadurch gekennzeichnet, daß die logische Schaltung einen Mikroprozessor (3) und eine Speicherschaltung (7) aufweist.

5. Fernsehempfänger nach einem der vorhergehenden Ansprüche, dadurch gekennzeichnet, daß die logische Schaltung (3) eine Vielzahl logischer Anschlüsse aufweist, die in einem Netzwerk durch eine verdrahtete Logik verbunden sind.

6. Fernsehempfänger nach einem der vorhergehenden Ansprüche, dadurch gekennzeichnet, daß das Modem (9) in dem Fernsehempfänger eingebaut ist.

7. Fernsehempfänger nach einem der Ansprüche 1 bis 5, dadurch gekennzeichnet, daß das Modem (9) vom Typ der akustischen Koppler ist.

8. Fernsehempfänger nach einem der vorhergehenden Ansprüche, dadurch gekennzeichnet, daß er in einer Speicherschaltung im Empfänger die Möglichkeit der Speicherung der Telefonnummer bietet, die der Empfänger mittels der logischen Schaltung (3) aufruft, um die Telefonverbindung mit der entfernten Station herzustellen.

9. Fernsehempfänger nach Anspruch 8, dadurch gekennzeichnet, daß die Telefonnummer, die gespeichert werden muß, auf der Tastatur der Empfängerfernbedienung eingegeben werden kann.

## Revendications

1. Récepteur de télévision comprenant un dispositif d'affichage d'images (6), des moyens de reproduction de signaux acoustiques, un accès de transmission de données (8) susceptibles d'être couplé à un modem (9) et à une ligne téléphonique (9'), un dispositif de commande (1) et un circuit logique (3) apte à répondre à une commande prédéterminée lancée par l'utilisateur via ledit dispositif de commande (1) et à fournir en conséquence une séquence de signaux audit accès (8), afin de permettre une transmission de données, via ledit modem (9) et la ligne téléphonique (9') à une station de réception éloignée, caractérisé en ce que ladite transmission de données contient des informations concernant l'état de fonctionnement du récepteur de télévision, et que le récepteur comprend également des moyens de circuit (4, 5) reliés audit circuit logique (3) et audit accès (8) pour la réception, au départ de ladite station éloignée, de signaux qui sont une réponse à ladite transmission de données, et pour communiquer ladite réponse à l'utilisateur.

2. Récepteur de télévision selon la revendication 1, caractérisé en ce que ladite réponse est communiquée à l'utilisateur, soit grâce à l'affichage d'instructions de réponse sur ledit dispositif d'affichage d'images (6), soit grâce à leur reproduction au moyen desdits moyens de reproduction de signaux acoustiques.

3. Récepteur de télévision selon la revendication 2, caractérisé en ce que lesdites instructions sont reproduites sous forme acoustique, par des signaux Morse, en correspondance aux instructions selon un code établi.

4. Récepteur de télévision selon l'une quelconque des revendications précédentes, caractérisé en ce que ledit circuit logique comprend un microprocesseur (3) et un circuit de mémoire (7).

5. Récepteur de télévision selon l'une quelconque des revendications précédentes, caractérisé en ce que ledit circuit logique (3) comprend une pluralité d'accès logiques, raccordés à un réseau par logique câblée.

6. Récepteur de télévision selon l'une quelconque des revendications précédentes, caractérisé en ce que ledit modem (9) est incorporé au récepteur de télévision.

7. Récepteur de télévision selon l'une quelconque des revendications 1 à 5, caractérisé en ce que ledit modem (9) est du type à couplage acoustique.

8. Récepteur de télévision selon l'une quelconque des revendications précédentes, caractérisé en ce qu'il présente la possibilité de mettre en mémoire dans un circuit de mémoire intégré au récepteur, le numéro de téléphone que le récepteur peut appeler pour établir à distance une liaison téléphonique avec la station, grâce audit circuit logique (3).

9. Récepteur de télévision selon la revendication 8, caractérisé en ce que ledit numéro de téléphone qu'il s'agit de mettre en mémoire peut être saisi sur le clavier de la télécommande du récepteur de télévision.
